(19) Europäisches Patentamt
European Patent Office
Office européen des brevets

(11) **EP 4 371 767 A1**

(12) **EUROPEAN PATENT APPLICATION**
published in accordance with Art. 153(4) EPC

(43) Date of publication:
**22.05.2024 Bulletin 2024/21**

(21) Application number: **22842030.3**

(22) Date of filing: **07.07.2022**

(51) International Patent Classification (IPC):
**B32B 27/00** (2006.01)   **B32B 27/34** (2006.01)
**C08G 73/10** (2006.01)   **H05K 1/03** (2006.01)

(52) Cooperative Patent Classification (CPC):
**B32B 27/00; B32B 27/34; C08G 73/10; H05K 1/03**

(86) International application number:
**PCT/JP2022/026928**

(87) International publication number:
**WO 2023/286686 (19.01.2023 Gazette 2023/03)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.07.2021  JP 2021117965**

(71) Applicant: **TOYOBO CO., LTD.**
**Osaka-shi, Osaka 530-0001 (JP)**

(72) Inventors:
• **TOKUDA, Kaya**
**Otsu-shi, Shiga 520-0292 (JP)**
• **OKUYAMA, Tetsuo**
**Otsu-shi, Shiga 520-0292 (JP)**
• **MAEDA, Satoshi**
**Otsu-shi, Shiga 520-0292 (JP)**
• **YONEMUSHI, Harumi**
**Otsu-shi, Shiga 520-0292 (JP)**
• **MIZUGUCHI, Denichirou**
**Otsu-shi, Shiga 520-0292 (JP)**

(74) Representative: **Vossius & Partner**
**Patentanwälte Rechtsanwälte mbB**
**Siebertstraße 3**
**81675 München (DE)**

(54) **MULTILAYER BODY OF INORGANIC SUBSTRATE AND TRANSPARENT HEAT-RESISTANT POLYMER FILM**

(57)    The present invention provides a multilayer body of an inorganic substrate and a heat-resistant polymer film, the multilayer body being suppressed in vibrations during handling. A multilayer body of a heat-resistant polymer film and an inorganic substrate according to the present invention does not substantially use an adhesive and is characterized in that: the heat-resistant polymer film is transparent; the tensile elastic modulus $E1$ (GPa) and the thickness $T1$ ($\mu$m) of the multilayer body satisfy formula (1); and the storage elastic modulus $E2$ (GPa) at 280°C and the thickness $T1$ ($\mu$m) of the multilayer body satisfy formula (2).

$$(1): 25{,}000 \leq E1 \times T1$$

$$(2): E2 \times T1 \leq 52{,}000$$

EP 4 371 767 A1

# EP 4 371 767 A1

**Description**

TECHNICAL FIELD

The present invention relates to a laminate in which a heat-resistant polymer film of a polyimide-based resin or the like is formed on an inorganic substrate. The laminate of the present invention is useful, for example, when a flexible device and a flexible wiring board in which an electronic element is formed on the surface of a flexible substrate are manufactured.

BACKGROUND ART

As substrate materials for the manufacture of flexible electronic devices, the use of heat-resistant polymer films such as polyimide (hereinafter also simply referred to as "polymer films") has been studied. Since these polymer films such as polyimide are manufactured in long roll shapes, it is generally accepted that a roll-to-roll manufacturing line is ideal for the manufacture of flexible devices as well.

Meanwhile, in a large number of conventional electronic devices such as display devices, sensor arrays, touch screens and printed wiring boards, hard and rigid substrates such as glass substrates, semiconductor wafers, or glass fiber reinforced epoxy substrates are used, and the manufacturing equipment is also configured on the premise of using such rigid substrates.

Based on this background, as a technique of manufacturing flexible electronic devices using existing manufacturing equipment, there are known techniques of manufacturing flexible electronic devices in the procedure of handling a polymer film in a state of being temporarily pasted to a rigid inorganic substrate such as a glass substrate used as a temporary support, processing an electronic device on the polymer film, and then peeling off the polymer film on which the electronic device is formed from the temporary support. (Patent Document 1)

As a technique of manufacturing flexible electronic devices using existing manufacturing equipment, there are known techniques of manufacturing flexible electronic devices by applying a polymer solution or a polymer precursor solution to a rigid substrate such as a glass substrate used as a temporary support, and drying the solution to form a precursor film, then converting the precursor into a polymer film by causing a chemical reaction to obtain a laminate of a temporary support and a polymer film, forming an electronic device on the polymer film in the same manner, and then peeling off the polymer film. (Patent Document 2)

However, in the process of forming a desired functional element on a laminate in which a polymer film and a support formed of an inorganic substance are bonded together, the laminate is often exposed to a high temperature. For example, in the formation of functional elements such as polysilicon and oxide semiconductors, a step performed in a temperature region of about 200°C to 600°C is required. A temperature of about 200°C to 300°C may be applied to the film in the fabrication of a hydrogenated amorphous silicon thin film, and further heating at about 450°C to 600°C may be required in order to heat and dehydrogenate amorphous silicon and obtain low-temperature polysilicon. Hence, the polymer film constituting the laminate is required to exhibit heat resistance, but as a matter of fact, polymer films which can withstand practical use in such a high temperature region are limited, and polyimide is selected in many cases.

In other words, in any technique, a laminate in a state where a rigid temporary support and a polymer film layer that is finally peeled off and becomes the base material of a flexible electronic device are superimposed one on the other is used. The laminate can be handled as a rigid plate material, and can be thus handled in the same manner as a glass substrate in equipment for manufacturing liquid crystal displays, plasma displays, organic EL displays, or the like using conventional glass substrates.

PRIOR ART DOCUMENTS

PATENT DOCUMENTS

Patent Document 1: JP-B-5152104
Patent Document 2: JP-B-5699606

SUMMARY OF THE INVENTION

PROBLEMS TO BE SOLVED BY THE INVENTION

A laminate of a heat-resistant polymer film and an inorganic substrate is handled using a robot fork or a vacuum lifter for glass transport in the display manufacturing process. Generally, the thickness of glass used for display applications is as thin as 700 um or less, and the glass edge vibrates in the thickness direction by the movement of robot fork when the glass is transported using a robot fork or the like. Particularly in a case where the size of the laminate is large, specifically when one side is 400 mm or more, the amplitude of vibration is large. When the amplitude of vibration was large, there are problems that the laminate is not transferred well between the robot forks, and the laminate vibrates greatly and the position is shifted when the laminate is lifted by the lift pins in the equipment.

Accordingly, the present invention is intended to solve the above problems, and an object thereof is to provide a laminate of a heat-resistant polymer film and an inorganic substrate, of which the swinging width during handling is suppressed.

MEANS FOR SOLVING THE PROBLEMS

As a result of intensive studies aimed at solving the above problems, the present inventors have found out that it is possible to suppress the swinging of a laminate of a heat-resistant polymer film and an inorganic substrate by maintaining the product of the elastic modulus and thickness of the laminate within a certain range, and have completed the present invention.

In other words, the present invention includes the following configurations.

[1] A laminate of a heat-resistant polymer film and an inorganic substrate that substantially does not use an adhesive, in which the heat-resistant polymer film is a transparent heat-resistant polymer film, a tensile modulus of elasticity $E_1$ (GPa) and a thickness $T_1$ ($\mu$m) of the laminate satisfy Formula (1):

$$25000 \leq E_1 \times T_1 \quad (1),$$

and

a storage modulus $E_2$ (GPa) at 280°C and the thickness $T_1$ ($\mu$m) of the laminate satisfy Formula (2):

$$E_2 \times T_1 \leq 52000 \quad (2).$$

[2] The laminate according to [1], in which a tensile modulus of elasticity of the heat-resistant polymer film is 3.5 GPa or more and 9 GPa or less.

[3] The laminate according to [1] or [2], in which a storage modulus of the heat-resistant polymer film is 9 GPa or less at 280°C.

[4] The laminate according to any one of [1] to [3], in which the heat-resistant polymer film has a heat shrinkage rate of ±0.9% or less when heated from 23°C to 250°C.

[5] The laminate according to any one of [1] to [4], in which a diameter of a circumscribed circle of the inorganic substrate is 400 mm or more.

[6] The laminate according to any one of [1] to [5], in which the laminate has an amount of warpage of 500pm or less after being heated at 280°C for 1 hour.

[7] The laminate according to any one of [1] to [6], in which the heat-resistant polymer film includes at least one selected from the group consisting of polyimide, polyamide, and polyamide-imide.

EFFECT OF THE INVENTION

In the laminate of the present invention, it is possible to suppress position shifting and the like in the process of transferring glass by a machine and using lift pins since the laminate swings little during handling. In particular, the present invention is effective in a system in which a large-sized inorganic substrate is used and the swinging width of glass is large.

BRIEF DESCRIPTION OF THE DRAWING

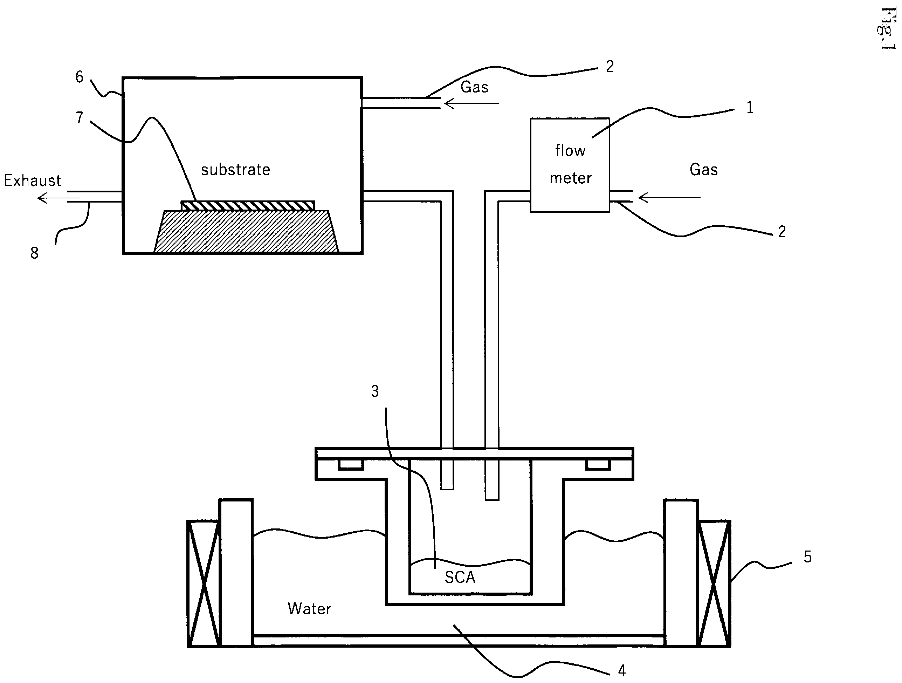

Fig. 1 is a schematic diagram illustrating an example of a silane coupling agent applying apparatus according to an embodiment of the present invention.

MODE FOR CARRYING OUT THE INVENTION

Hereinafter, embodiments of the present invention will be described.

<Heat-resistant polymer film>

The heat-resistant polymer film of the present invention is a transparent heat-resistant polymer film (hereinafter also simply referred to as polymer film). Examples of the heat-resistant polymer film include films of polyimide-based resins (for example, aromatic polyimide resin and alicyclic polyimide resin) such as polyimide, polyamide-imide, polyetherimide and fluorinated polyimide; polyamide; aromatic polyamide; and polyamide-imide.

However, since the polymer film is premised on being used in a process involving heat treatment at 300°C or more, those that can actually be adopted among the exemplified polymer films are limited. Among the polymer films, films obtained using so-called super engineering plastics are preferable, and more specific examples thereof include an aromatic polyimide film, an aromatic amide film, and an aromatic amide-imide film. The heat-resistant polymer film of the present invention preferably includes at least one selected from the group consisting of polyimide, polyamide, and polyamide-imide.

The details of polyimide-based resin films (also referred to as polyimide films or transparent polyimide films in some cases), which are an example of the polymer film, will be described below. Generally, a polyimide-based resin film is obtained by applying a polyamic acid (polyimide precursor) solution which is obtained by a reaction between a diamine and a tetracarboxylic acid in a solvent, to a support for polyimide film fabrication, drying the solution to form a green film (hereinafter, also called as a "polyamic acid film"), and treating the green film by heat at a high temperature to cause a dehydration ring-closure reaction on the support for polyimide film fabrication or in a state of being peeled off from the support.

For the application of the polyamic acid (polyimide precursor) solution, it is possible to appropriately use, for example, conventionally known solution application means such as spin coating, doctor blade, applicator, comma coater, screen printing method, slit coating, reverse coating, dip coating, curtain coating, and slit die coating.

As the transparency of transparent polyimide, it is preferable that the total light transmittance is 75% or more. The total light transmittance is more preferably 80% or more, still more preferably 85% or more, yet still more preferably 87% or more, particularly preferably 88% or more. The upper limit of the total light transmittance of transparent polyimide is not particularly limited, but is preferably 98% or less, more preferably 97% or less for use as a flexible electronic device. The colorless and transparent polyimide in the present invention is preferably polyimide having a total light transmittance of 75% or more. The method for measuring total light transmittance of the polymer film is as described in Examples.

Examples of the aromatic tetracarboxylic acids for obtaining highly colorless and transparent polyimide include tetracarboxylic acids such as 4,4'-(2,2-hexafluoroisopropyridene)diphthalic acid, 4,4'-oxydiphthalic acid, bis(1,3-dioxo-1,3-dihydro-2-benzofuran-5-carboxylic acid) 1,4-phenylene, bis(1,3-dioxo-1,3-dihydro-2-benzofuran-5-yl)benzene-1,4-dicarboxylate, 4,4'-[4,4'-(3-oxo-1,3-dihydro-2-benzofuran-1,1-diyl) bis(benzene-1,4-diyloxy)]dibenzene-1,2-dicarboxylic acid, 3,3',4,4'-benzophenonetetracarboxylic acid, 4,4'-[(3-oxo-1,3-dihydro-2-benzofuran-1,1-diyl) bis(toluene-2,5-diyloxy)]dibenzene-1,2-dicarboxylic acid, 4,4'-[(3-oxo-1,3-dihydro-2-benzofuran-1,1-diyl) bis(1,4-xylene-2,5-diyloxy)]dibenzene-1,2-dicarboxylic acid, 4,4'-[4,4'-(3-oxo-1,3-dihydro-2-benzofuran-1,1-diyl) bis(4-isopropyltoluene-2,5-diyloxy)]dibenzene-1,2-dicarboxylic acid, 4,4'-[4,4'-(3-oxo-1,3-dihydro-2-benzofuran-1,1-diyl) bis(naphthalene-1,4-diyloxy)]dibenzene-1,2-dicarboxylic acid, 4,4'-[4,4'-(3H-2,1-benzoxathiol-1,1-dioxide-3,3-diyl) bis(benzene-1,4-diyloxy)]dibenzene-1,2-dicarboxylic acid, 4,4'-benzophenone tetracarboxylic acid, 4,4'-[(3H-2,1-benzoxathiol-1,1-dioxide-3,3-diyl) bis(toluene-2,5-diyloxy)]dibenzene-1,2-dicarboxylic acid, 4,4'-[(3H-2,1-benzoxathiol-1,1-dioxide-3,3-diyl) bis(1,4-xylene-2,5-diyloxy)]dibenzene-1,2-dicarboxylic acid, 4,4'-[4,4'-(3H-2,1-benzoxathiol-1,1-dioxide-3,3-diyl) bis(4-isopropyltoluene-2,5-diyloxy)]dibenzene-1,2-dicarboxylic acid, 4,4'-[4,4'-(3H-2,1-benzoxathiol-1,1-dioxide-3,3-diyl) bis(naphthalene-1,4-diyloxy)]dibenzene-1,2-dicarboxylic acid, 3,3',4,4'-benzophenonetetracarboxylic acid, 3,3',4,4'-benzophenonetetracarboxylic acid, 3,3',4,4'-diphenylsulfonetetracarboxylic acid, 3,3',4,4'-biphenyltetracarboxylic acid, 2,3,3',4'-biphenyltetracarboxylic acid, pyromellitic acid, 4,4'-[spiro(xanthene-9,9'-fluorene)-2,6-diyl bis(oxycarbonyl)]diphthalic acid, and 4,4'-[spiro(xanthene-9,9'-fluorene)-3,6-diyl bis(oxycarbonyl)] diphthalic acid, and acid anhydrides thereof. Among these, dianhydrides having two acid anhydride structures are suitable, and particularly 4,4'-(2,2-hexafluoroisopropyridene)diphthalic dianhydride and 4,4'-oxydiphthalic dianhydride are preferable. The aromatic tetracarboxylic acids may be used singly or in combination of two or more kinds thereof. For obtaining high heat resistance, the amount of the aromatic tetracarboxylic acids copolymerized is, for example, preferably 50% by mass or more, more preferably 60% by mass or more, still more preferably 70% by mass or more, yet still more preferably 80% by mass or more, particularly preferably 90% by mass or more of the total amount of all the tetracarboxylic acids, and may be 100% by mass.

Examples of the alicyclic tetracarboxylic acids include tetracarboxylic acids such as 1,2,3,4-cyclobutanetetracarboxylic acid, 1,2,3,4-cyclopentanetetracarboxylic acid, 1,2,3,4-cyclohexanetetracarboxylic acid, 1,2,4,5-cyclohexanetetracarboxylic acid, 3,3',4,4'-bicyclohexyltetracarboxylic acid, bicyclo[2,2,1]heptane-2,3,5,6-tetracarboxylic acid, bicyclo[2,2,2]octane-2,3,5,6-tetracarboxylic acid, bicyclo[2,2,2]octo-7-ene-2,3,5,6-tetracarboxylic acid, tetrahydroanthracene-2,3,6,7-tetracarboxylic acid, tetradecahydro-1,4:5,8:9,10-trimethanoanthracene-2,3,6,7-tetracarboxylic acid, decahydronaphthalene-2,3,6,7-tetracarboxylic acid, decahydro-1,4:5,8-dimethanonaphthalene-2,3,6,7-tetracarboxylic acid, decahydro-1,4-ethano-5,8-methanonaphthalene-2,3,6,7-tetracarboxylic acid, norbornane-2-spiro-α-cyclopentanone-α'-spiro-2"-norbornane-5,5'',6,6"-tetracarboxylic acid (also known as "norbornane-2-spiro-2'-cyclopentanone-5'-spiro-2"-norbornane-5,5', 6, 6"-tetracarboxylic acid"), methylnorbornane-2-spiro-α-cyclopentanone-α'-spiro-2"-(methylnorbornane)-5,5' , 6, 6"-tetracarboxylic acid, norbornane-2-spiro-α-cyclohexanone-α'-spiro-2"-norbornane-5,5', 6, 6"-tetracarboxylic acid (also known as "norbornane-2-spiro-2'-cyclohexanone-6'-spiro-2'-norbornane-5,5' , 6, 6"-tetracarboxylic acid"), methylnorbornane-2-spiro-α-cyclohexanone-α'-spiro-2"-(methylnorbornane)-5,5',6,6"-tetracarboxylic acid, norbornane-2-spiro-α-cyclopropanone-α'-spiro-2"-norbornane-5,5",6,6'-tetracarboxylic acid, norbornane-2-spiro-α-cyclobutanone-α'-spiro-2"-norbornane-5,5",6,6"-tetracarboxylic acid, norbornane-2-spiro-α-cycloheptanone-α'-spiro-2"-norbornane-5,5",6,6"-tetracarboxylic acid, norbornane-2-spiro-α-cyclooctanone-α'-spiro-2"-norbornane-5,5",6,6'-tetracarboxylic acid, norbornane-2-spiro-α-cyclononanone-α'-spiro-2"-norbornane-5,5",6,6"-tetracarboxylic acid, norbornane-2-spiro-α-cyclodecanone-α'-spiro-2"-norbornane-5,5",6,6"-tetracarboxylic acid, norbornane-2-spiro-α-cycloundecanone-α'-spiro-2"-norbornane-5,5",6,6'-tetracarboxylic acid, norbornane-2-spiro-α-cyclododecanone-α'-spiro-2"-norbornane-5,5",6,6'-tetracarboxylic acid, norbornane-2-spiro-α-cyclotridecanone-α'-spiro-2"-norbornane-5,5",6,6"-tetracarboxylic acid, norbornane-2-spiro-α-cyclotetradecanone-α'-spiro-2"-norbornane-5,5",6,6"-tetracarboxylic acid, norbornane-2-spiro-α-cyclopentadecanone-α'-spiro-2"-norbornane-5,5",6,6"-tetracarboxylic acid, norbornane-2-spiro-α-(methylcyclopentanone)-α'-spiro-2"-norbornane-5,5",6,6"-tetracarboxylic acid, and norbornane-2-spiro-α-(methylcyclohexanone)-α'-spiro-2"-norbornane-5,5",6,6"-tetracarboxylic acid, and acid anhydrides thereof. Among these, dianhydrides having two acid anhydride structures are suitable, particularly 1,2,3,4-cyclobutanetetracarboxylic dianhydride, 1,2,3,4-cyclohexanetetracarboxylic dianhydride, and 1,2,4,5-cyclohexanetetracarboxylic dianhydride are preferable, 1,2,3,4-cyclobutanetetracarboxylic dianhydride and 1,2,4,5-cyclohexanetetracarboxylic dianhydride are more preferable, and 1,2,3,4-cyclobutanetetracarboxylic dianhydride is still more preferable. These may be used singly or in combination of two or more kinds thereof. For obtaining high transparency, the amount of the aromatic tetracarboxylic acids copolymerized is, for example, preferably 50% by mass or more, more preferably 60% by mass or more, still more preferably 70% by mass or more, yet still more preferably 80% by mass or more, particularly preferably 90% by mass or more of the total amount of all the tetracarboxylic acids, and may be 100% by mass.

Examples of the tricarboxylic acids include aromatic tricarboxylic acids such as trimellitic acid, 1,2,5-naphthalenetricarboxylic acid, diphenyl ether-3,3',4'-tricarboxylic acid, and diphenylsulfone-3,3',4'-tricarboxylic acid, or hydrogenated products of the aromatic tricarboxylic acids such as hexahydrotrimellitic acid, and alkylene glycol bistrimellitates such as ethylene glycol bistrimellitate, propylene glycol bistrimellitate, 1,4-butanediol bistrimellitate, and polyethylene glycol bistrimellitate and monoanhydrides and esterified products thereof. Among these, monoanhydrides having one acid anhydride structure are suitable, and particularly trimellitic anhydride and hexahydrotrimellitic anhydride are preferable. These may be used singly or a plurality of these may be used in combination.

Examples of the dicarboxylic acids include aromatic dicarboxylic acids such as terephthalic acid, isophthalic acid, orthophthalic acid, naphthalenedicarboxylic acid, and 4,4'-oxydibenzenecarboxylic acid, or hydrogenated products of the aromatic dicarboxylic acids such as 1,6-cyclohexanedicarboxylic acid, and oxalic acid, succinic acid, glutaric acid, adipic acid, heptanedioic acid, octanedioic acid, azelaic acid, sebacic acid, undecanedioic acid, dodecanedioic acid, and 2-methylsuccinic acid and acid chlorides or esterified products thereof. Among these, aromatic dicarboxylic acids and hydrogenated products thereof are suitable, and particularly terephthalic acid, 1,6-cyclohexanedicarboxylic acid, and 4,4'-oxydibenzenecarboxylic acid are preferable. The dicarboxylic acids may be used singly or a plurality of these may be used in combination.

The diamines or isocyanates for obtaining highly colorless and transparent polyimide are not particularly limited, and it is possible to use aromatic diamines, aliphatic diamines, alicyclic diamines, aromatic diisocyanates, aliphatic diisocyanates, alicyclic diisocyanates and the like that are usually used in the polyimide synthesis, polyamide-imide synthesis, and polyamide synthesis. Aromatic diamines are preferable from the viewpoint of heat resistance, and alicyclic diamines are preferable from the viewpoint of transparency. When aromatic diamines having a benzoxazole structure are used, a high elastic modulus, low heat shrinkability, and a low coefficient of linear thermal expansion as well as high heat resistance can be exerted. The diamines and isocyanates may be used singly or in combination of two or more kinds thereof.

Examples of the aromatic diamines include: 2,2'-dimethyl-4,4'-diaminobiphenyl; 1,4-bis[2-(4-aminophenyl)-2-propyl]benzene; 1,4-bis(4-amino-2-trifluoromethylphenoxy)benzene; 2,2'-ditrifluoromethyl-4,4'-diaminobiphenyl; 4,4'-bis(4-aminophenoxy)biphenyl; 4,4'-bis(3-aminophenoxy)biphenyl; bis[4-(3-aminophenoxy)phenyl]ketone; bis[4-(3-aminophenoxy)phenyl]sulfide; bis[4-(3-aminophenoxy)phenyl] sulfone; 2,2-bis[4-(3-aminophenoxy)phenyl]propane; 2,2-bis[4-(3-aminophenoxy)phenyl]-1,1,1,3,3,3-hexafluoropropane; m-phenylenediamine; o-phenylenediamine; p-phenylenediamine; m-aminobenzylamine; p-aminobenzylamine; 4-amino-N-(4-aminophenyl)benzamide; 3,3'-diaminodiphenylether; 3,4'-diaminodiphenylether; 4,4'-diaminodiphenylether; 2,2'-trifluoromethyl-4,4'-diaminodiphenylether; 3,3'-diaminodiphenylsulfide; 3,4'-diaminodiphenylsulfide; 4,4'-diaminodiphenylsulfide; 3,3'-diaminodiphenylsulfoxide; 3,4'-diaminodiphenylsulfoxide; 4,4'-diaminodiphenylsulfoxide; 3,3'-diaminodiphenyl sulfone; 3,4'-diaminodiphenyl sulfone; 4,4'-diaminodiphenyl sulfone; 3,3'-diaminobenzophenone; 3,4'-diaminobenzophenone; 4,4'-diaminobenzophenone; 3,3'-diaminodiphenylmethane; 3,4'-diaminodiphenylmethane; 4,4'-diaminodiphenylmethane; bis[4-(4-aminophenoxy)phenyl]methane; 1,1-bis[4-(4-aminophenoxy)phenyl]ethane; 1,2-bis[4-(4-aminophenoxy)phenyl]ethane; 1,1-bis[4-(4-aminophenoxy)phenyl]propane; 1,2-bis[4-(4-aminophenoxy)phenyl]propane; 1,3-bis[4-(4-aminophenoxy)phenyl]propane; 2,2-bis[4-(4-aminophenoxy)phenyl]propane; 1,1-bis[4-(4-aminophenoxy)phenyl]butane; 1,3-bis[4-(4-aminophenoxy)phenyl]butane; 1,4-bis[4-(4-aminophenoxy)phenyl]butane; 2,2-bis[4-(4-aminophenoxy)phenyl]butane; 2,3-bis[4-(4-aminophenoxy)phenyl]butane; 2-[4-(4-aminophenoxy)phenyl]-2-[4-(4-aminophenoxy)-3-methylphenyl]propane; 2,2-bis[4-(4-aminophenoxy)-3-methylphenyl]propane; 2-[4-(4-aminophenoxy)phenyl]-2-[4-(4-aminophenoxy)-3,5-dimethylphenyl]propane; 2,2-bis[4-(4-aminophenoxy)-3,5-dimethylphenyl]propane; 2,2-bis[4-(4-aminophenoxy)phenyl]-1,1,1,3,3,3-hexafluoropropane; 1,4-bis(3-aminophenoxy)benzene; 1,3-bis(3-aminophenoxy)benzene; 1,4-bis(4-aminophenoxy)benzene; 4,4'-bis(4-aminophenoxy)biphenyl; bis[4-(4-aminophenoxy)phenyl]ketone; bis[4-(4-aminophenoxy)phenyl]sulfide; bis[4-(4-aminophenoxy)phenyl]sulfoxide; bis[4-(4-aminophenoxy)phenyl] sulfone; bis[4-(3-aminophenoxy)phenyl]ether; bis[4-(4-aminophenoxy)phenyl]ether; 1,3-bis[4-(4-aminophenoxy)benzoyl]benzene; 1,3-bis[4-(3-aminophenoxy)benzoyl]benzene; 1,4-bis[4-(3-aminophenoxy)benzoyl]benzene; 4,4'-bis[(3-aminophenoxy)benzoyl]benzene; 1,1-bis[4-(3-aminophenoxy)phenyl]propane; 1,3-bis[4-(3-aminophenoxy)phenyl]propane; 3,4'-diaminodiphenylsulfide; 2,2-bis[3-(3-aminophenoxy)phenyl]-1,1,1,3,3,3-hexafluoropropane; bis[4-(3-aminophenoxy)phenyl]methane; 1,1-bis[4-(3-aminophenoxy)phenyl]ethane; 1,2-bis[4-(3-aminophenoxy)phenyl]ethane; bis[4-(3-aminophenoxy)phenyl]sulfoxide; 4,4'-bis[3-(4-aminophenoxy)benzoyl]diphenylether; 4,4'-bis[3-(3-aminophenoxy)benzoyl]diphenylether; 4,4'-bis[4-(4-amino-$\alpha,\alpha$-dimethylbenzyl)phenoxy]benzophenone; 4,4'-bis[4-(4-amino-$\alpha,\alpha$-dimethylbenzyl)phenoxy]diphenyl sulfone; bis[4-{4-(4-aminophenoxy)phenoxy}phenyl] sulfone; 1,4-bis[4-(4-aminophenoxy)phenoxy-$\alpha,\alpha$-dimethylbenzyl]benzene; 1,3-bis[4-(4-aminophenoxy)phenoxy-$\alpha,\alpha$-dimethylbenzyl]benzene; 1,3-bis[4-(4-amino-6-trifluoromethylphenoxy)-$\alpha,\alpha$-dimethylbenzyl]benzene; 1,3-bis[4-(4-amino-6-fluorophenoxy)-$\alpha,\alpha$-dimethylbenzyl]benzene; 1,3-bis[4-(4-amino-6-methylphenoxy)-$\alpha,\alpha$-dimethylbenzyl]benzene; 1,3-bis[4-(4-amino-6-cyanophenoxy)-$\alpha,\alpha$-dimethylbenzyl]benzene; 3,3'-diamino-4,4'-diphenoxybenzophenone; 4,4'-diamino-5,5'-diphenoxybenzophenone; 3,4'-diamino-4,5'-diphenoxybenzophenone; 3,3'-diamino-4-phenoxybenzophenone; 4,4'-diamino-5-phenoxybenzophenone, 3,4'-diamino-4-phenoxybenzophenone; 3,4'-diamino-5'-phenoxybenzophenone; 3,3'-diamino-4,4'-dibiphenoxybenzophenone; 4,4'-diamino-5,5'-dibiphenoxybenzophenone; 3,4'-diamino-4,5'-dibiphenoxybenzophenone; 3,3'-diamino-4-biphenoxybenzophenone; 4,4'-diamino-5-biphenoxybenzophenone; 3,4'-diamino-4-biphenoxybenzophenone; 3,4'-diamino-5'-biphenoxybenzophenone; 1,3-bis(3-amino-4-phenoxybenzoyl)benzene; 1,4-bis(3-amino-4-phenoxybenzoyl)benzene; 1,3-bis(4-amino-5-phenoxybenzoyl)benzene; 1,4-bis(4-amino-5-phenoxybenzoyl)benzene; 1,3-bis(3-amino-4-biphenoxybenzoyl)benzene, 1,4-bis(3-amino-4-biphenoxybenzoyl)benzene; 1,3-bis(4-amino-5-biphenoxybenzoyl)benzene; 1,4-bis(4-amino-5-biphenoxybenzoyl)benzene; 2,6-bis[4-(4-amino-$\alpha,\alpha$-dimethylbenzyl)phenoxy]benzonitrile; 4,4'-[9H-fluorene-9,9-diyl]bisaniline (also known as "9,9-bis(4-aminophenyl)fluorene"); spiro(xanthene-9,9'-fluorene)-2,6-diyl bis(oxycarbonyl)]bisaniline; 4,4'-[spiro(xanthene-9,9'-fluorene)-2,6-diyl bis(oxycarbonyl)]bisaniline; and 4,4'-[spiro(xanthene-9,9'-fluorene)-3,6-diyl bis(oxycarbonyl)]bisaniline. A part or all of hydrogen atoms on an aromatic ring of the above-described aromatic diamines may be substituted with halogen atoms; alkyl groups or alkoxyl groups having 1 to 3 carbon atoms; or cyano groups, and further a part or all of hydrogen atoms of the alkyl groups or alkoxyl groups having 1 to 3 carbon atoms may be substituted with halogen atoms. The aromatic diamines having a benzoxazole structure are not particularly limited, and examples thereof include: 5-amino-2-(p-aminophenyl)benzoxazole; 6-amino-2-(p-aminophenyl)benzoxazole; 5-amino-2-(m-aminophenyl)benzoxazole; 6-amino-2-(m-aminophenyl)benzoxazole; 2,2'-p-phenylenebis(5-aminobenzoxazole); 2,2'-p-phenylenebis(6-aminobenzoxazole); 1-(5-aminobenzoxazolo)-4-(6-aminobenzoxazolo)benzene; 2,6-(4,4'-diaminodiphenyl)benzo[1,2-d:5,4-d']bisoxazole; 2,6-(4,4'-diaminodiphenyl)benzo[1,2-d:4,5-d']bisoxazole; 2,6-(3,4'-diaminodiphenyl)benzo[1,2-d:5,4-d']bisoxazole; 2,6-(3,4'-diaminodiphenyl)benzo[1,2-d:4,5-d']bisoxazole; 2,6-(3,3'-diaminodiphenyl)benzo[1,2-d:5,4-d']bisoxazole; and 2,6-(3,3'-diaminodiphenyl)benzo[1,2-d:4,5-d']bisoxazole. Among these, particularly 2,2'-ditrifluoromethyl-4,4'-diaminobiphenyl, 4-amino-N-(4-aminophenyl)benzamide, 4,4'-diaminodiphenyl sulfone, and 3,3'-diaminobenzophenone are preferable. The aromatic diamines may be used singly or a plurality of these may be used in combination.

Examples of the alicyclic diamines include 1,4-diaminocyclohexane, 1,4-diamino-2-methylcyclohexane, 1,4-diamino-2-ethylcyclohexane, 1,4-diamino-2-n-propylcyclohexane, 1,4-diamino-2-isopropylcyclohexane, 1,4-diamino-2-n-butylcyclohexane, 1,4-diamino-2-isobutylcyclohexane, 1,4-diamino-2-sec-butylcyclohexane, 1,4-diamino-2-tert-butylcyclohexane, and 4,4'-methylenebis(2,6-dimethylcyclohexylamine). Among these, particularly 1,4-diaminocyclohexane and 1,4-diamino-2-methylcyclohexane are preferable, and 1,4-diaminocyclohexane is more preferable. The alicyclic diamines may be used singly or a plurality of these may be used in combination.

Examples of the diisocyanates include aromatic diisocyanates such as diphenylmethane-2,4'-diisocyanate, 3,2'- or 3,3'- or 4,2'- or 4,3'- or 5,2'- or 5,3'- or 6,2'- or 6,3'-dimethyldiphenylmethane-2,4'-diisocyanate, 3,2'- or 3,3'- or 4,2'- or 4,3'- or 5,2'- or 5,3'- or 6,2'- or 6,3'-diethyldiphenylmethane-2,4'-diisocyanate, 3,2'- or 3,3'- or 4,2'- or 4,3'- or 5,2'- or 5,3'- or 6,2'- or 6,3'-dimethoxydiphenylmethane-2,4'-diisocyanate, diphenylmethane-4,4'-diisocyanate, diphenylmethane-3,3'-diisocyanate, diphenylmethane-3,4'-diisocyanate, diphenyl ether-4,4'-diisocyanate, benzophenone-4,4'-diisocyanate, diphenylsulfone-4,4'-diisocyanate, tolylene-2,4-diisocyanate, tolylene-2,6-diisocyanate, m-xylylene diisocyanate, p-xylylene diisocyanate, naphthalene-2,6-diisocyanate, 4,4'-(2,2 bis(4-phenoxyphenyl)propane)diisocyanate, 3,3'- or 2,2'-dimethylbiphenyl-4,4'-diisocyanate, 3,3'- or 2,2'-diethylbiphenyl-4,4'-diisocyanate, 3,3'-dimethoxybiphenyl-4,4'-diisocyanate, and 3,3'-diethoxybiphenyl-4,4'-diisocyanate, and hydrogenated diisocyanates of any of these (for example, isophorone diisocyanate, 1,4-cyclohexane diisocyanate, 1,3-cyclohexane diisocyanate, 4,4'-dicyclohexylmethane diisocyanate, and hexamethylene diisocyanate). Among these, diphenylmethane-4,4'-diisocyanate, tolylene-2,4-diisocyanate, tolylene-2,6-diisocyanate, 3,3'-dimethylbiphenyl-4,4'-diisocyanate, naphthalene-2,6-diisocyanate, 4,4'-dicyclohexylmethane diisocyanate, and 1,4-cyclohexane diisocyanate are preferable from the viewpoint of low moisture absorption property, dimensional stability, price, and polymerizability. The diisocyanates may be used singly or a plurality of these may be used in combination.

In the present embodiment, the polymer film is preferably a polyimide film. When the polymer film is a polyimide film, the polymer film exhibits excellent heat resistance. When the polymer film is a polyimide film, the laminate can be suitably cut with an ultraviolet laser.

The thickness of the polymer film is preferably 3 um or more, more preferably 7 um or more, still more preferably 14 um or more, yet still more preferably 20 um or more. The upper limit of the thickness of the polymer film is not particularly limited but is preferably 250 um or less, more preferably 100 um or less, still more preferably 50 um or less for use as a flexible electronic device.

The average coefficient of linear thermal expansion (CTE) of the polymer film at between 30°C and 250°C is preferably 50 ppm/K or less. The CTE is more preferably 45 ppm/K or less, still more preferably 40 ppm/K or less, yet still more preferably 30 ppm/K or less, particularly preferably 20 ppm/K or less. The CTE is preferably -5 ppm/K or more, more preferably -3 ppm/K or more, still more preferably 1 ppm/K or more. When the CTE is in the above range, a small difference in coefficient of linear thermal expansion between the polymer film and a general support (inorganic substrate) can be maintained, and the polymer film and the inorganic substrate can be prevented from peeling off from each other or warping together with the support when being subjected to a process of applying heat as well. Here, CTE is a factor that indicates reversible expansion and contraction with respect to temperature. The CTE of the polymer film refers to the average value of the CTE in the application direction (MD direction) of the polymer solution or polymer precursor solution and the CTE in the transverse direction (TD direction). The method for measuring CTE of the polymer film is as described in Examples.

In a case where the polymer film is a transparent polyimide film, the yellowness index (hereafter, also referred to as "yellow index" or "YI") of the transparent polyimide film is preferably 10 or less, more preferably 7 or less, still more preferably 5 or less, yet still more preferably 3 or less. The lower limit of the yellowness index of the transparent polyimide is not particularly limited, but is preferably 0.1 or more, more preferably 0.2 or more, still more preferably 0.3 or more for use as a flexible electronic device. The method for measuring YI of the polymer film is as described in Examples.

When the polymer film is a transparent polyimide film, the haze of the transparent polyimide film is preferably 1.0 or less, more preferably 0.8 or less, still more preferably 0.5 or less, yet still more preferably 0.3 or less. The lower limit of haze is not particularly limited, but industrially, there is no problem when the haze is 0.01 or more and the haze may be 0.05 or more. The method for measuring haze of the polymer film is as described in Examples.

The heat shrinkage rate of the polymer film at between 23°C and 500°C is preferably ± 0.9%, more preferably ±0.6%, still more preferably ±0.2% or less. The heat shrinkage rate is a factor that represents irreversible expansion and contraction with respect to the temperature. The method for measuring heat shrinkage rate of the polymer film is as described in Examples.

Examples of the method for controlling the heat shrinkage rate within the above range include a technique in which the stress applied to the polymer film in a heated environment is diminished when the polymer film is formed. Specifically, in a case where the polymer film is a polyimide film, the control of heat shrinkage rate can be achieved by relaxing the tension in the MD and TD directions applied to the film when the green film is treated at a high temperature.

The tensile breaking strength of the polymer film is preferably 60 MPa or more, more preferably 80 MP or more, still more preferably 100 MPa or more. The upper limit of the tensile breaking strength is not particularly limited but is practically less than about 1000 MPa. When the tensile breaking strength is 60 MPa or more, it is possible to prevent the polymer film from breaking when being peeled off from the inorganic substrate. The tensile breaking strength of the polymer film refers to the average value of the tensile breaking strength in the machine direction (MD direction) and the tensile breaking strength in the transverse direction (TD direction) of the polymer film.

The tensile breaking elongation of the polymer film is preferably 1% or more, more preferably 5% or more, still more preferably 10% or more. When the tensile breaking elongation is 1% or more, the handleability is excellent. The tensile breaking elongation of the polymer film refers to the average value of the tensile breaking elongation in the machine direction (MD direction) and the tensile breaking elongation in the transverse direction (TD direction) of the polymer film.

The tensile modulus of elasticity of the polymer film is preferably 3.5 GPa or more, still more preferably 4 GPa or more. When the tensile modulus of elasticity is 3.5 GPa or more, the polymer film is less expanded and deformed when being peeled off from the inorganic substrate and exhibits excellent handleability. When the tensile modulus of elasticity of the polymer film is 3.5 GPa or more, the swinging width can be kept small during transportation and handling of the laminate in a laminate of the polymer film and an inorganic substrate. The tensile modulus of elasticity is preferably 9 GPa or less, more preferably 8.8 GPa or less, still more preferably 8.5 GPa or less. When the tensile modulus of elasticity is 9 GPa or less, the polymer film can be used as a flexible film. When the tensile modulus of elasticity of the polymer film is 9 GPa or less, warpage of the laminate after being heated can be suppressed in a laminate of an inorganic substrate and the polymer film. Moreover, when the tensile modulus of elasticity of the polymer film is 9 GPa or less, the storage modulus of the polymer film at 280°C is likely to be 9 GPa or less. The storage modulus of the polymer film at 280°C is preferably 9 GPa or less, more preferably GPa or less, still more preferably 6 GPa or less. The storage modulus is preferably 0.1 GPa or more, more preferably 0.5 GPa or more, still more preferably 1 GPa or more. When the tensile modulus of elasticity of the polymer film exceeds 9 GPa, the laminate may warp greatly since the force of the polymer film to deform the inorganic substrate is large when the polymer film shrinks by heat shrinkage. When the storage modulus at 280°C exceeds 9GPa, the force of the polymer film to deform the inorganic substrate is large, thus the polymer film undergone dimensional changes due to heat shrinkage and expansion by CTE at high temperatures may deform the laminate and the laminate may warp greatly. The tensile modulus of elasticity and storage modulus of the polymer film refers to the average value of the tensile modulus of elasticity in the machine direction (MD direction) and the tensile modulus of elasticity in the transverse direction (TD direction) of the polymer film. The method for measuring the tensile modulus of elasticity and storage modulus of the polymer film is as described in Examples.

Unevenness of the thickness of the polymer film is preferably 20% or less, more preferably 12% or less, still more preferably 7% or less, particularly preferably 4% or less. When the unevenness of the thickness exceeds 20%, the polymer film tends to be hardly adopted to a narrow portion. Incidentally, unevenness of the thickness of a film can be determined based on the following equation from film thicknesses, which are measured at about 10 randomly extracted positions of a film to be measured by using, for example, a contact-type film thickness meter.

Unevenness of thickness of film (%) = 100 × (maximum film thickness - minimum film thickness) ÷ average film thicness

The polymer film is preferably obtained in the form of being wound as a long polymer film having a width of 300 mm or more and a length of 10 m or more at the time of production, more preferably in the form of a roll-shaped polymer film wound around a winding core. When the polymer film is wound in a roll shape, it is easy to transport the polymer film in the form of a polymer film wound in a roll shape.

In order to secure handleability and productivity of the polymer film, a lubricant (particles) having a particle size of about 10 to 1000 nm is preferably added to/contained in the polymer film at about 0.03 to 3% by mass to impart fine unevenness to the surface of the polymer film and secure slipperiness.

<Inorganic substrate>

The inorganic substrate may be a plate-type substrate which can be used as a substrate made of an inorganic substance, and examples thereof include those mainly composed of glass plates, ceramic plates, semiconductor wafers, metals and the like and those in which these glass plates, ceramic plates, semiconductor wafers, and metals are laminated, those in which these are dispersed, and those in which fibers of these are contained as the composite of these.

Examples of the glass plates include quartz glass, high silicate glass (96% silica), soda lime glass, lead glass, aluminoborosilicate glass, and borosilicate glass (Pyrex (registered trademark)), borosilicate glass (alkali-free), borosilicate glass (microsheet), aluminosilicate glass and the like. Among these, those having a coefficient of linear thermal expansion of 5 ppm/K or less are desirable, and in the case of a commercially available product, "Corning (registered trademark) 7059", "Corning (registered trademark) 1737", and "EAGLE" manufactured by Corning Inc., "AN100" manufactured by AGC Inc., "OA10" and "OA11G" manufactured by Nippon Electric Glass Co., Ltd., "AF32" manufactured by SCHOTT AG, and the like that are glass for liquid crystal are desirable.

The semiconductor wafer is not particularly limited, but examples thereof include a silicon wafer and wafers of germanium, silicon-germanium, gallium-arsenide, aluminum-gallium-indium, nitrogen-phosphorus-arsenic-antimony, SiC, InP (indium phosphide), InGaAs, GaInNAs, LT, LN, ZnO (zinc oxide), CdTe (cadmium telluride), ZnSe (zinc selenide) and the like. Among these, the wafer preferably used is a silicon wafer, and a mirror-polished silicon wafer having a size of 8 inches or more is particularly preferable.

The metals include single element metals such as W, Mo, Pt, Fe, Ni, and Au, alloys such as Inconel, Monel, Nimonic, carbon-copper, Fe-Ni-based Invar alloy, and Super Invar alloy, and the like. Multilayer metal plates formed by adding another metal layer or a ceramic layer to these metals are also included. In this case, when the overall coefficient of linear thermal expansion (CTE) with the additional layer is low, Cu, Al and the like are also used in the main metal layer. The metals used as the addition metal layer is not limited as long as they are those that strengthen the close contact property with the transparent heat-resistant polymer film, those that have properties that there is no diffusion and the chemical resistance and heat resistance are favorable, but suitable examples thereof include Cr, Ni, TiN, and Mo-containing Cu.

Examples of the ceramic plate in the present invention include ceramics for substrate such as $Al_2O_3$, mullite, ALN, SiC, crystallized glass, cordierite, spodumene, $Pb-BSG+CaZrO_3+Al_2O_3$, crystallized glass+$Al_2O_3$, crystallized Ca-BSG, BSG+quartz, BSG+$Al_2O_3$, Pb-BSG+$Al_2O_3$, glass-ceramic, and zerodur material.

It is desirable that the flat portion of the inorganic substrate is sufficiently flat. Specifically, the P-V value of the surface roughness is 50 nm or less, more preferably 20 nm or less, and further preferably 5 nm or less. When the surface is coarser than this, the peel strength between the polymer film layer and the inorganic substrate may be insufficient.

The thickness of the inorganic substrate is not particularly limited, but a thickness of 10 mm or less is preferable, a thickness of 3 mm or less is more preferable, and a thickness of 1.3 mm or less is still more preferable from the viewpoint of handleability. The lower limit of the thickness is not particularly limited but is preferably 0.07 mm or more, more preferably 0.15 mm or more, and further preferably 0.3 mm or more. When the inorganic substrate is too thin, the inorganic substrate is easily destroyed and it is difficult to handle the inorganic substrate. When the inorganic substrate is too thick, the inorganic substrate is heavy and it is difficult to handle the inorganic substrate.

The tensile modulus of elasticity of the inorganic substrate is preferably 50 GPa or more, more preferably 60 GPa or more, still more preferably 65 GPa or more. The upper limit of the tensile modulus of elasticity is 80 GPa, more preferably 78 GPa or less. When the tensile modulus of elasticity of the inorganic substrate is within the above range, the handleability is excellent.

<Laminate>

The laminate of the present invention is obtained by laminating the transparent heat-resistant polymer film and the inorganic substrate substantially without using an adhesive. In a case where the transparent heat-resistant polymer film has a laminated configuration of two or more layers, it is preferable that the transparent heat-resistant polymer film includes a transparent heat-resistant polymer film that is in contact with the inorganic substrate and a transparent heat-resistant polymer film layer that is not in contact with the inorganic substrate but is adjacent to the transparent heat-resistant polymer film layer.

The shape of the laminate is not particularly limited and may be square or rectangular. The shape of the laminate is preferably rectangular, and the length of the long side is preferably 300 mm or more, more preferably 500 mm or more, still more preferably 1000 mm or more. The upper limit is not particularly limited, but industrially, a length of 20000 mm or less is sufficient and the length may be 10000 mm or less.

In the present invention, the size of the inorganic substrate is preferably such that the diameter of the circumscribed circle has a size of 400 mm or more when the inorganic substrate is rectangular. By using an inorganic substrate of this size, it is possible to sufficiently acquire the effect of improving handleability of the laminate, which is the effect of the present invention. The diameter is more preferably 450 mm or more, still more preferably 500 mm or more. The upper limit is not particularly limited, but industrially, a diameter of 1000 mm or less is sufficient, and the diameter may be 800 mm or less.

In the present invention, the tensile modulus of elasticity E1 and thickness T1 of the laminate of a transparent heat-resistant polymer film and an inorganic substrate satisfy Formula (1).

$$25,000 \leq E1 \times T1 \quad (1)$$

$E1 \times T1$ is preferably 26000 or more, more preferably 28000 or more, still more preferably 30,000 or more, particularly preferably 35,000 or more. The upper limit is not particularly limited, but is preferably 60,000 or less, more preferably 50,000 or less, still more preferably 45,000 or less. When $E1 \times T1$ is within the above range, the swinging width of the inorganic substrate during handling of the laminate can be diminished. Here, the unit of E1 is GPa and the unit of T1 is $\mu$m.

The tensile modulus of elasticity E1 of the laminate is preferably 40 GPa or more, more preferably 50 GPa or more, still more preferably 60 GPa or more and is preferably 120 GPa or less, more preferably 100 GPa or less, still more preferably 80 GPa or less. The thickness T1 of the laminate is preferably 100 um or more, more preferably 300 um or more, still more preferably 500 um or more and is preferably 1000 $\mu$m or less, more preferably 800 $\mu$m or less, still more preferably 600 $\mu$m or less. When the tensile modulus of elasticity E1 and thickness T1 of the laminate are within the above ranges, Formula (1) is likely to be satisfied. Meanwhile, the methods for measuring the tensile modulus of elasticity E1 and thickness T1 of the laminate are as described in Examples.

In the present invention, the storage modulus at 280°C E2 and thickness T1 of the laminate of a transparent heat-resistant polymer film and an inorganic substrate satisfy Formula (2).

$$E2 \times T1 \leq 52,000 \quad (2)$$

E2 × T1 is preferably 50,000 or less, more preferably 45,000 or less, still more preferably 42,000 or less, still more preferably 40,000 or less. The lower limit is not particularly limited, but is preferably 10,000 or more, more preferably 20,000 or more, still more preferably 25,000 or more. When E2 × T1 is within the above range, warpage of the laminate during heating at a high temperature can be suppressed. Here, the unit of E2 is GPa and the unit of T1 is $\mu$m.

The storage modulus of the laminate at 280°C is preferably 30 GPa or more, more preferably 50 GPa or more, still more preferably 70 GPa or more and is preferably 120 GPa or less, more preferably 100 GPa or less, still more preferably 80 GPa or less. When the storage modulus E2 and thickness T1 of the laminate are within the above ranges, Formula (2) is likely to be satisfied. Meanwhile, the method for measuring the storage modulus E2 of the laminate at 280°C is as described in Examples.

In other words, as the laminate of the present invention satisfies Formulas (1) and (2) simultaneously, it is possible to diminish swinging width of the inorganic substrate during handling of the laminate, and to suppress warpage of the laminate during heating at a high temperature. The values of Formulas (1) and (2) can be controlled by selecting a transparent heat-resistant polymer film having suitable thickness and elastic modulus and adjusting the thickness of the inorganic substrate.

In the present invention, it is preferable that warpage of the laminate of a transparent heat-resistant polymer film and an inorganic substrate is 500 um or less after the laminate has been heated at 280°C for 1 hour. When the warpage of the laminate after being heated at 280°C for 1 hour, that is, after being subjected to a process performed at a high temperature is 500 um or less, it is easy to handle the laminate with lift pins and robot forks. Moreover, the warpage is less likely to interfere in a case where coating is performed using a coater in a post-process.

<Adhesive>

An adhesive layer is substantially not interposed between the inorganic substrate and the transparent heat-resistant polymer film of the present invention. Here, the adhesive layer in the present invention refers to a layer containing a Si (silicon) component at less than 10% as a mass ratio (less than 10% by mass). Substantially not used (not interposed) means that the thickness of the adhesive layer interposed between the inorganic substrate and the transparent heat-resistant polymer film is preferably 0.4 um or less, more preferably 0.3 um or less, still more preferably 0.2 um or less, particularly preferably 0.1 um or less, most preferably 0 $\mu$m.

<Silane coupling agent (SCA)>

In the laminate, it is preferable to have a layer of a silane coupling agent between the transparent heat-resistant polymer film and the inorganic substrate. In the present invention, the silane coupling agent refers to a compound containing a Si (silicon) component at 10% by mass or more. By using the silane coupling agent layer, the intermediate layer between the transparent heat-resistant polymer film and the inorganic substrate can be thinned, and thus there are effects that the amounts of degassed components during heating are small, elution hardly occurs in a wet process as well, and only trace amounts of components are eluted even if elution occurs. The silane coupling agent preferably contains a large amount of silicon oxide component since the heat resistance is improved, and is particularly preferably one exhibiting heat resistance at a temperature of about 400°C. The thickness of the silane coupling agent layer is preferably less than 0.2 um. As a range for use as a flexible electronic device, the thickness of the silane coupling agent layer is preferably 100 nm or less (0.1 um or less), more desirably 50 nm or less, still more desirably 10 nm. When a silane coupling agent layer is normally fabricated, the thickness thereof is about 0.10 um or less. In processes where it is desired to use as little silane coupling agent as possible, a silane coupling agent layer having a thickness of 5 nm or less can also be used. There is the possibility that the peel strength decreases or some parts are not be attached when the thickness is 1 nm or less, and it is thus desirable that the thickness of the silane coupling agent layer is 1 nm or more.

The silane coupling agent in the present invention is not particularly limited, but one having an amino group or an epoxy group is preferable. Specific examples of the silane coupling agent include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilanevinyltrichlorosilane, vinyltrimethoxysilane, vinyltriethoxysilane, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-phenyl-3-aminopropyltrimethoxysilane, N-(vinylbenzyl)-2-aminoethyl-3-aminopropyltrimethoxysilane hydrochloride, 3-ureidopropyltriethoxysilane, 3-chloropropyltrimethoxysilane, 3-mercaptopropylmethyldimethoxysilane, 3-mercaptopropyltrimethoxysilane, bis(triethoxysilylpropyl)tetrasulfide, 3-isocyanatepropyltriethoxysilane, tris-(3-trimethoxysilylpropyl)isocyanurate, chloromethylphenetyltrimethoxysilane, and chloromethyltrimethoxysilane. Among these, preferred examples include N-2-(aminoethyl)-3-aminopropylmethyldimethoxysilane, N-2-(aminoethyl)-3-aminopropyltrimethoxysilane, N-2-(aminoethyl)-3-aminopropyltriethoxysilane, 3-aminopropyltrimethoxysilane, 3-aminopropyltriethoxysilane, 3-triethoxysilyl-N-(1,3-dimethyl-butylidene)propylamine, 2-(3,4-epoxycyclohexyl)ethyltrimethoxysilane, 3-glycidoxypropyltrimethoxysilane, 3-glycidoxypropylmethyldiethoxysilane, 3-glycidoxypropyltriethoxysilane, aminophenyltrimethoxysilane, aminophenetyltrimethoxysilane, and aminophenylaminomethylphenetyltrimethoxysilane. When heat resistance is required in the process, a silane coupling agent, in which Si and an amino group or the like is linked to each other via an aromatic, is desirable.

It is preferable that the adhesive strength between the transparent heat-resistant polymer film and the inorganic substrate is 0.3 N/cm or less. This makes it remarkably easy to peel off the transparent heat-resistant polymer film from the inorganic substrate after a device is formed on the transparent heat-resistant polymer film. Hence, it is possible to manufacture a device connected body that can be produced in a large quantity and it is easy to manufacture a flexible electronic device. The adhesive strength is preferably 0.25 N/cm or less, more preferably 0.2 N/cm or less, still more preferably 0.15 N/cm or less, particularly preferably 0.1 N/cm or less. The peel strength is preferably 0.01 N/cm or more. The peel strength is more preferably 0.02 N/cm or more, still more preferably 0.03 N/cm or more, particularly preferably 0.05 N/cm or more since the laminate does not peel off when a device is formed on the transparent heat-resistant polymer film. The adhesive strength is a value of the laminate after the transparent heat-resistant polymer film and the inorganic substrate are bonded together and then subjected to heat treatment at 100°C for 10 minutes in an air atmosphere (initial adhesive strength). It is preferable that the adhesive strength of a laminate obtained by further subjecting the laminate at the time of initial adhesive strength measurement to heat treatment at 200°C for 1 hour in a nitrogen atmosphere is also within the above range (adhesive strength after heat treatment at 200°C).

The laminate of the present invention can be fabricated, for example, according to the following procedure. A laminate can be obtained by treating at least one surface of the inorganic substrate with a silane coupling agent in advance, superimposing the surface treated with a silane coupling agent on the transparent heat-resistant polymer film, and pressurizing the two for lamination. A laminate can also be obtained by treating at least one surface of the transparent heat-resistant polymer film with a silane coupling agent in advance, superimposing the surface treated with a silane coupling agent on the inorganic substrate, and pressurizing the two for lamination. Examples of the pressurization method include ordinary pressing or lamination in the air or pressing or lamination in a vacuum, but lamination in the air is desirable for large-sized laminates (for example, more than 200 mm) in order to acquire stable adhesive strength over the entire surface. In contrast, pressing in a vacuum is preferable in the case of a laminate having a small size of about 200 mm or less. As the degree of vacuum, a degree of vacuum obtained by an ordinary oil-sealed rotary pump is sufficient, and about 10 Torr or less is sufficient. The pressure is preferably 1 MPa to 20 MPa, still more preferably 3 MPa to 10 MPa. The substrate may be destroyed when the pressure is high, and close contact may not be achieved at some portions when the pressure is low. The temperature is preferably 90°C to 300°C, still more preferably 100°C to 250°C. The film may be damaged when the temperature is high, and the close contact force may be weak when the temperature is low.

The laminate of the present invention can also be fabricated by coating an inorganic substrate with a precursor solution of a transparent heat-resistant polymer or a transparent heat-resistant polymer solution and performing heating.

<Fabrication of flexible electronic device>

When the laminate is used, a flexible electronic device can be easily fabricated by using existing equipment and processes for electronic device manufacture. Specifically, a flexible electronic device can be fabricated by forming an electronic element or wiring (electronic device) on the transparent heat-resistant polymer film of the laminate and peeling off the electronic element or wiring (electronic device) together with the transparent heat-resistant polymer film from the laminate.

In the present specification, the electronic device refers to a wiring board which carries out electrical wiring and has a single-sided, double-sided, or multilayered structure, electronic circuits including active devices such as transistors and diodes and passive devices such as resistors, capacitors, and inductors, sensor elements which sense pressure, temperature, light, humidity and the like, biosensor elements, light emitting elements, image display elements such as liquid crystal displays, electrophoresis displays, and self-luminous displays, wireless and wired communication elements, arithmetic elements, storage elements, MEMS elements, solar cells, thin film transistors, and the like.

In the method for manufacturing a flexible electronic device in the present invention, a device is formed on the transparent heat-resistant polymer film of the laminate fabricated by the above-described method and then the transparent heat-resistant polymer film is peeled off from the inorganic substrate.

EXAMPLES

Hereinafter, the present invention will be described in detail with reference to Examples, but the present invention is not limited to the following Examples as long as the gist of the present invention is not exceeded.

<Preparation of heat-resistant polymer film>

Commercially available colored films were used as films F5 to F8 used in Comparative Examples.

    F5: XENOMAX (registered trademark) F38LR2 (polyimide film manufactured by TOYOBO CO., LTD., thickness: 38 $\mu$m)
    F6: XENOMAX (registered trademark) F15LR2 (polyimide film manufactured by TOYOBO CO., LTD., thickness: 15 $\mu$m)
    F7: UPILEX (registered trademark) 25S (polyimide film manufactured by UBE Corporation, thickness: 25 $\mu$m)
    F8: XENOMAX (registered trademark) F50LR2 (polyimide film manufactured by TOYOBO CO., LTD., thickness: 50 $\mu$m)

<Preparation of polyamic acid solution A1>

The inside of a reaction vessel equipped with a nitrogen introducing tube, a reflux tube, and a stirring bar was purged with nitrogen, then 33.36 parts by mass of 2,2'-bis(trifluoromethyl)benzidine (TFMB), 270.37 parts by mass of N-methyl-2-pyrrolidone (NMP), and a dispersion obtained by dispersing colloidal silica in dimethylacetamide ("SNOWTEX (registered trademark) DMAC-ST" manufactured by Nissan Chemical Corporation) were added so that silica was 0.14% by mass of the total amount of polymer solids in the polyamic acid solution, and completely dissolved. Subsequently, 9.81 parts by mass of 1,2,3,4-cyclobutanetetracarboxylic dianhydride (CBDA), 11.34 parts by mass of 3,3',4,4'-biphenyltetracarboxylic acid (BPDA), 4.85 parts by mass of (ODPA) were added dividedly in the solid form, and the mixture was then stirred at room temperature for 24 hours. Thereafter, 165.7 parts by mass of DMAc was added for dilution, thereby obtaining a polyamic acid solution A1 having a solid content of 18% by mass and a reduced viscosity of 2.7 dl/g (molar ratio of TFMB//CBDA/BPDA/ODPA = 1.00//0.48/0.37/0.15).

<Fabrication of transparent heat-resistant polymer film F1>

The polyamic acid solution A1 was adjusted and applied onto the lubricant-free surface of polyethylene terephthalate film A4100 (manufactured by TOYOBO CO., LTD.) using a comma coater so that the final film thickness was 25 um. This was dried at 90 to 110°C for 10 minutes. The polyamic acid film that gained self-supporting properties after drying was peeled off from the support, allowed to pass through a pin tenter with a pin sheet having pins disposed, and gripped by inserting the film edges into the pins, the pin sheet interval was adjusted so that the film did not break and unnecessary slackening did not occur, and the film was transported and heated at 250°C for 3 minutes, at 300°C for 3 minutes, and at 370°C for 6 minutes to conduct the imidization reaction. Thereafter, the film was cooled to room temperature for 2 minutes, the portions exhibiting poor flatness at both edges of the film were cut off using a slitter, and the film was wound into a roll shape, thereby obtaining a polyimide film F1 having a width of 450 mm by 500 m.

<Fabrication of transparent heat-resistant polymer film F2>

A transparent heat-resistant polymer film F2 was obtained in the same manner as the transparent heat-resistant polymer film F1 except that the final film thickness was set to 15 $\mu$m.

<Preparation of polyimide solution A2>

While nitrogen gas was introduced into a reaction vessel equipped with a nitrogen introducing tube, a Dean-Stark tube and a reflux tube, a thermometer, and a stirring bar, 19.86 parts by mass of 4,4'-diaminodiphenyl sulfone (4,4'-DDS), 4.97 parts by mass of 3,3'-diaminodiphenyl sulfone (3,3'-DDS), and 80 parts by mass of gamma-butyrolactone (GBL) were added. Subsequently, 31.02 parts by mass of 4,4'-oxydiphthalic dianhydride (ODPA), 24 parts by mass of GBL, and 13 parts by mass of toluene were added at room temperature, then the temperature was raised to an internal temperature of 160°C, and the mixture was heated under reflux at 160°C for 1 hour for imidization. After the imidization was completed, the temperature was raised to 180°C, and the reaction was continuously conducted while extracting toluene. After the reaction for 12 hours, the oil bath was removed, the temperature was returned to room temperature, and GBL was added so that the solid concentration was 20% by mass, thereby obtaining a polyimide solution A2 having a reduced viscosity of 0.70 dl/g (molar ratio of 4,4'-DDS/3,3'-DDS//ODPA = 0.80/0.20//1.00).

<Fabrication of transparent heat-resistant polymer film F3>

The polyimide solution A2 was adjusted and applied onto the lubricant-free surface of polyethylene terephthalate film A4100 (manufactured by TOYOBO CO., LTD.) using a comma coater so that the final film thickness was 25 um. The polyethylene terephthalate film A4100 was allowed to pass through a hot air furnace, wound up, and dried at 100°C for 10 minutes at this time. The polyamic acid film that gained self-supporting properties after drying was peeled off from the support, allowed to pass through a pin tenter with a pin sheet having pins disposed, and gripped by inserting the film edges into the pins, the pin sheet interval was adjusted so that the film did not break and unnecessary slackening did not occur, and the film was transported and heated at 200°C for 3 minutes, at 250°C for 3 minutes, and at 300°C for 6 minutes to conduct the imidization reaction. Thereafter, the film was cooled to room temperature for 2 minutes, the portions exhibiting poor flatness at both edges of the film were cut off using a slitter, and the film was wound into a roll shape, thereby obtaining a polyimide film F3 having a width of 450 mm by 500 m.

<Fabrication of transparent heat-resistant polymer film F4>

A transparent heat-resistant polymer film F4 was obtained in the same manner as the transparent heat-resistant polymer film F3 except that the final film thickness was set to 15 um.

<Inorganic substrate>

Commercially available inorganic substrates S1 to S3 were used.

S1: OA-10G (manufactured by Nippon Electric Glass Co., Ltd., thickness: 0.5 mm)
S2: OA-10G (manufactured by Nippon Electric Glass Co., Ltd., thickness: 0.3 mm)
S3: OA-10G (manufactured by Nippon Electric Glass Co., Ltd., thickness: 0.7 mm)

<Measurement of heat-resistant polymer film thickness>

The thickness of the heat-resistant polymer film was measured using a macrometer (Millitron 1245D manufactured by Feinpruf GmbH). The results are presented in Table 1.

<Measurement of laminate thickness (T1)>

The thickness (T1) of the laminate was measured using High Accuracy Digimatic Digital Micrometer (MDH-25M manufactured by Mitutoyo Corporation). The results are presented in Table 1.

<Tensile modulus of elasticity of heat-resistant polymer film>

The heat-resistant polymer films F1 to F8 were cut into a strip shape of 100 mm × 10 mm in the machine direction (MD direction) and the transverse direction (TD direction) respectively to be used as test pieces. The tensile modulus of elasticity in the MD direction and the TD direction were measured respectively at a tensile speed of 50 mm/min and a distance between chucks of 40 mm using a tensile tester (Autograph Model Name: AG-5000A manufactured by Shimadzu Corporation). The results are presented in Table 1.

<Tensile modulus of elasticity (E1) of laminate>

The laminate of an inorganic substrate and a heat-resistant polymer film was cut into a strip shape of 100 mm × 10 mm in the machine direction of the film using a glass cutter respectively to be used as a test piece. The tensile modulus of elasticity (E1) in the MD direction and the TD direction were measured respectively at a tensile speed of 50 mm/min and a distance between chucks of 40 mm using a tensile tester (Autograph Model Name: AG-5000A manufactured by Shimadzu Corporation). The results are presented in Table 1.

<Storage modulus of laminate at 280°C (E2)>

The storage modulus of the laminate was determined by measuring the storage modulus of the heat-resistant polymer film and the storage modulus of the inorganic substrate and performing the following calculation. First, Q800 manufactured by TA Instruments was used to measure the storage modulus of the heat-resistant polymer film. The measurement was performed at an initial load of 0.02 N, a frequency of 10 Hz, a sample width of 5 mm, a chuck distance of 20 mm, and 5°C/min in a range of 30°C to 400°C, and the storage modulus at 280°C was measured. In a case where the upper measurement limit of the instrument was exceeded and measurement was not possible, the dynamic viscoelasticity of the heat-resistant polymer film was measured under the same conditions. The storage modulus of the inorganic substrate was measured using itkDVA-225, and the storage modulus of the laminate at 280°C (E2) was calculated by the following equation.

Storage modulus of laminate at 280°C (E2) = {storage modulus of heat-resistant polymer film at 280°C × heat-resistant polymer film thickness/(laminate thickness)} + {storage modulus of inorganic substrate at 280°C × inorganic substrate thickness/(laminate thickness)}

<Heat shrinkage rate of heat-resistant polymer film>

A strip-shaped sample of 15 × 20 cm were cut out from the heat-resistant polymer film at positions 10 cm from the L edge, center, and 10 cm from the R edge. This strip was subjected to humidity conditioning at 23°C and 50% RH for 24 hours, and then marked at intervals of 10 cm. After that, the strip was heated at 250°C for 1 hour, and subjected to humidity conditioning again at 23°C and 50% RH for 24 hours, and then the heat shrinkage rate was measured by measuring the intervals between marks. For length measurement, VISION MEASUREING MACHINE manufactured by Mitutoyo Corporation was used, and the measurement was performed by n = 2 for each kind of film. The results are presented in Table 1.

<Coefficient of linear thermal expansion (CTE) of heat-resistant polymer film>

The expansion/contraction rate of the heat-resistant polymer films (polyimide films) F1 to F8 in the machine direction (MD direction) and the transverse direction (TD direction) was measured under the following conditions, the expansion/contraction rate/temperature was measured at intervals of 15°C, such as 30°C to 45°C and 45°C to 60°C, this measurement was performed up to 300°C, and the average value of all measured values was calculated as CTE. The results are presented in Table 1.

Device name; TMA4000S produced by MAC Science Corporation
Length of sample; 20 mm
Width of sample; 2 mm
Start temperature in temperature increase; 25°C
End temperature in temperature increase; 300°C
Rate of temperature increase; 5°C/min
Atmosphere; Argon

<Total light transmittance>

The total light transmittance (TT) of the heat-resistant polymer film was measured using HAZEMETER (NDH5000 manufactured by NIPPON DENSHOKU INDUSTRIES CO., LTD.). A D65 lamp was used as the light source. The same measurement was performed 3 times and the arithmetic mean value thereof was adopted. The results are presented in Table 1.

<Yellow index (YI)>

Using a color meter (ZE6000 manufactured by NIPPON DENSHOKU INDUSTRIES CO., LTD.) and a C2 light source, the tristimulus values, XYZ values of the heat-resistant polymer film were measured in conformity with ASTM D1925, and the yellow index (YI) was calculated by the following equation. The same measurement was performed 3 times and the arithmetic mean value thereof was adopted. The results are presented in Table 1.

$$YI = 100 \times (1.28X - 1.06Z)/Y$$

<Haze>

The haze of the heat-resistant polymer film was measured using HAZEMETER (NDH5000 manufactured by NIPPON DENSHOKU INDUSTRIES CO., LTD.). A D65 lamp was used as the light source. The same measurement was performed 3 times and the arithmetic mean value thereof was adopted. The results are presented in Table 1.

(Example 1)

The method of applying a silane coupling agent to the inorganic substrate S1 was performed using the apparatus illustrated in Fig. 1. Fig. 1 is a schematic diagram of an apparatus for applying a silane coupling agent to the inorganic substrate S1. The inorganic substrate S1 (cut into a size of 370 mm × 470 mm) was used. The inorganic substrate S1 was washed with pure water, dried, then irradiated using a UV/O3 irradiator (SKR1102N-03 manufactured by LANTECHNICAL SERVICE CO., LTD.) for 1 minute for dry cleaning, and use. Into a chemical tank having a capacity of 1 L, 150 g of 3-aminopropyltrimethoxysilane (silane coupling agent, Shin-Etsu Chemical KBM903) was put, and the outer water bath of this chemical tank was warmed to 43°C. The vapor that came out was then sent to the chamber together with clean dry air. The gas flow rate was set to 25 L/min and the substrate temperature was set to 24°C. The temperature of clean dry air was 23°C and the humidity thereof was 1.2% RH. Since the exhaust is connected to the exhaust port having a negative pressure, it is confirmed that the chamber has a negative pressure of about 10 Pa by a differential pressure gauge.
Next, the heat-resistant polymer film F1 (size of 360 mm × 460 mm) was bonded on the silane coupling agent layer to obtain a laminate. A laminator manufactured by MCK CO., LTD. was used for bonding, and the bonding conditions were set to compressed air pressure: 0.6 MPa, temperature: 22°C, humidity: 55% RH, and lamination speed: 50 mm/sec. This F1/S1 laminate was heated at 110°C for 10 minutes to obtain an inorganic substrate/heat-resistant polymer film laminate.

(Examples 2 to 4 and Comparative Examples 1 to 4)

The same operation as in Example 1 was performed by changing the combination of an inorganic substrate and a heat-resistant polymer film. The combinations are presented in Table 1. The polymer films of Comparative Examples 1 to 4 were colored, and thus the total light transmittance, YI, haze and CTE thereof were not measured.

<Measurement of 90° adhesive strength (peel strength)>

For the laminate obtained as described above, the 90° peel strength between the inorganic substrate and the heat-resistant polymer film was measured.
The measurement conditions for 90° initial peel strength are as follows.
The film is peeled off from the inorganic substrate at an angle of 90°.
The measurement is performed 5 times and the average value thereof is taken as the measured value.

Measuring instrument; Autograph AG-IS manufactured by Shimadzu Corporation
Measured temperature; Room temperature (25°C)
Peeling speed; 100 mm/min
Atmosphere; Air
Width of measured sample; 2.5 cm

<Warpage of laminate>

The laminate obtained as described above was heated at 280°C for 1 hour. The laminate after being heated was returned to room temperature and allowed to still stand in a nitrogen-purged box for 24 hours. The laminate was taken out of the box, placed on a surface table with the inorganic substrate facing down within 10 minutes, and shim plates having a thickness of 500 um were inserted into the four corners of the laminate. Evaluation was carried out as follows. The results are presented in Table 1.
In a case where there was at least one corner where the shim plate could be inserted without being caught, it was evaluated as ×.
In a case where there was one or less corner where the shim plate is caught on the inorganic substrate, and the inorganic substrate and the shim plate were in contact with each other, but there was at least one corner where insertion was possible, it was evaluated as Δ.

In a case where there were two or three corners where the shim plate was caught on the inorganic substrate, it was evaluated as O.

In a case where the shim plate was caught on the inorganic substrate at all the corners, it was evaluated as ◎.

<Swinging of laminate>

The fabricated laminate was placed on a workbench with the film side facing downward, and a camera (VH-Z20R manufactured by Keyence) was set at the position with a height of 15 cm from the top plate of the workbench. A suction lifter (manufactured by Bohole, 50 kg) was set so that the suction cups were aligned at the central part of the laminate in the long side direction. The handle of the suction lifter was held, the laminate was pulled up by 15 cm at a speed of 10 cm/sec, and the swinging width (mm) of the laminate was measured from the captured moving image. The results are presented in Table 1.

[Table 1]

| | Example 1 | Example 2 | Example 3 | Example 4 | Comparative Example 1 | Comparative Example 2 | Comparative Example 3 | Comparative Example 4 |
|---|---|---|---|---|---|---|---|---|
| Transparent heat-resistant polymer film | F1 | F2 | F3 | F4 | F5 | F6 | F7 | F8 |
| Thickness of transparent heat-resistant polymer film ($\mu$m) | 25 | 15 | 25 | 15 | 38 | 15 | 25 | 50 |
| Tensile modulus of elasticity of transparent heat-resistant polymer film (GPa) | 4.1 | 4.1 | 4 | 4 | 9 | 9 | 9 | 9 |
| Total light transmittance of transparent heat-resistant polymer film (%) | 88 | 88 | 91 | 91 | - | - | - | - |
| YI of transparent heat-resistant polymer film | 4.1 | 4.1 | 2.6 | 2.6 | - | - | - | - |
| Haze of transparent heat-resistant polymer film | 0.4 | 0.4 | 0.3 | 0.3 | - | - | - | - |
| CTE of transparent heat-resistant polymer film (ppm/K) | 28 | 28 | 49 | 49 | - | - | - | - |
| Inorganic substrate | S1 | S1 | S1 | S1 | S2 | S2 | S2 | S3 |

(continued)

|  | Example 1 | Example 2 | Example 3 | Example 4 | Comparative Example 1 | Comparative Example 2 | Comparative Example 3 | Comparative Example 4 |
|---|---|---|---|---|---|---|---|---|
| Thickness of inorganic substrate (μm) | 500 | 500 | 500 | 500 | 300 | 300 | 300 | 700 |
| E1 (GPa) | 70.5 | 71.8 | 70.5 | 71.7 | 66.5 | 70.7 | 68.8 | 64.5 |
| T1 (μm) | 525 | 525 | 525 | 515 | 338 | 315 | 325 | 750 |
| E1 × T1 | 37013 | 37695 | 37013 | 36926 | 22477 | 22271 | 22360 | 48375 |
| E2 (GPa) | 71.7 | 72.3 | 70.4 | 71.7 | 64.4 | 70.7 | 68.7 | 69.4 |
| E2 × T1 | 37643 | 37958 | 36960 | 36926 | 21767 | 22271 | 22328 | 52050 |
| Storage modulus of heat-resistant polymer film at 280°C (GPa) | 2.2 | 2.2 | 1.5 | 1.5 | 8 | 8 | 6. 9 | 8 |
| Heat shrinkage rate of heat-resistant polymer film by heating at 250°C (%) | 0.01 | 0.01 | 0.08 | 0.08 | 0.01 | 0.01 | 0.06 | 0.03 |
| Diameter of circumscribed circle of inorganic substrate (mm) | 598 | 598 | 598 | 598 | 598 | 598 | 598 | 598 |
| Warpage of laminate after heated at 280°C | ◎ | ◎ | ○ | ○ | ◎ | ◎ | × | Δ |
| Swinging width of laminate (mm) | 12 | 15 | 12 | 12 | 24 | 32 | 30 | 8 |
| 90 degree peel strength of laminate (N/cm) | 0.1 | 0.1 | 0.08 | 0.08 | 0.12 | 0.17 | 0.2 | 0.08 |

DESCRIPTION OF REFERENCE SIGNS

1 Flow meter
2 Gas inlet
3 Chemical tank (silane coupling agent tank)
4 Hot water tank (water bath)
5 Heater
6 Processing chamber (chamber)
7 Base material
8 Exhaust port

**Claims**

1. A laminate of a heat-resistant polymer film and an inorganic substrate that substantially does not use an adhesive, wherein

   the heat-resistant polymer film is a transparent heat-resistant polymer film,
   a tensile modulus of elasticity E1 (GPa) and a thickness T1 (um) of the laminate satisfy Formula (1):

   $$25000 \leq E1 \times T1 \quad (1),$$

   and
   a storage modulus E2 (GPa) at 280°C and the thickness T1 (um) of the laminate satisfy Formula (2):

   $$E2 \times T1 \leq 52000 \quad (2).$$

2. The laminate according to claim 1, wherein a tensile modulus of elasticity of the heat-resistant polymer film is 3.5 GPa or more and 9 GPa or less.

3. The laminate according to claim 1 or 2, wherein a storage modulus of the heat-resistant polymer film is 9 GPa or less at 280°C.

4. The laminate according to any one of claims 1 to 3, wherein the heat-resistant polymer film has a heat shrinkage rate of ±0.9% or less when heated from 23°C to 250°C.

5. The laminate according to any one of claims 1 to 4, wherein a diameter of a circumscribed circle of the inorganic substrate is 400 mm or more.

6. The laminate according to any one of claims 1 to 5, wherein the laminate has an amount of warpage of 500pm or less after being heated at 280°C for 1 hour.

7. The laminate according to any one of claims 1 to 6, wherein the heat-resistant polymer film includes at least one selected from the group consisting of polyimide, polyamide, and polyamide-imide.

Fig.1

## INTERNATIONAL SEARCH REPORT

International application No.

**PCT/JP2022/026928**

### A. CLASSIFICATION OF SUBJECT MATTER

***B32B 27/00***(2006.01)i; ***B32B 27/34***(2006.01)i; ***C08G 73/10***(2006.01)i; ***H05K 1/03***(2006.01)i
FI:  B32B27/00 B; B32B27/34; C08G73/10; H05K1/03 610N

According to International Patent Classification (IPC) or to both national classification and IPC

### B. FIELDS SEARCHED

Minimum documentation searched (classification system followed by classification symbols)

B32B1/00-43/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2014/119648 A1 (TOYOBO CO., LTD.) 07 August 2014 (2014-08-07) paragraphs [0023], [0034], [0082]-[0099], examples 2, 3 | 1-7 |
| X | JP 2019-119126 A (TOYOBO CO., LTD.) 22 July 2019 (2019-07-22) paragraphs [0023], [0048]-[0071], paragraph [0052], application example 2 | 1-7 |
| A | JP 2020-59169 A (TOYOBO CO., LTD.) 16 April 2020 (2020-04-16) | 1-7 |
| A | JP 2015-104843 A (SAMSUNG ELECTRONICS CO., LTD.) 08 June 2015 (2015-06-08) | 1-7 |
| A | JP 2021-62571 A (AGC INC) 22 April 2021 (2021-04-22) | 1-7 |

☐ Further documents are listed in the continuation of Box C.   ☑ See patent family annex.

| | | |
|---|---|---|
| *  Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family | |

| Date of the actual completion of the international search | Date of mailing of the international search report |
|---|---|
| **24 August 2022** | **06 September 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/026928**

| Patent document cited in search report | | | Publication date (day/month/year) | Patent family member(s) | | | Publication date (day/month/year) |
|---|---|---|---|---|---|---|---|
| WO | 2014/119648 | A1 | 07 August 2014 | TW | 201434629 | A | |
| JP | 2019-119126 | A | 22 July 2019 | (Family: none) | | | |
| JP | 2020-59169 | A | 16 April 2020 | (Family: none) | | | |
| JP | 2015-104843 | A | 08 June 2015 | US | 2015/0151514 | A1 | |
| | | | | KR | 10-2015-0062945 | A | |
| JP | 2021-62571 | A | 22 April 2021 | CN | 112659657 | A | |
| | | | | KR | 10-2021-0045313 | A | |
| | | | | TW | 202124154 | A | |

Form PCT/ISA/210 (patent family annex) (January 2015)

**EP 4 371 767 A1**

**REFERENCES CITED IN THE DESCRIPTION**

**Patent documents cited in the description**

- JP 5152104 B
- JP 5699606 B